# EUROPÄISCHE PATENTSCHRIFT

(11) **EP 2 148 368 B1**
(45) Veröffentlichungstag und Bekanntmachung des Hinweises auf die Patenterteilung: **18.04.2018**
(21) Anmeldenummer: 09008707.3
(22) Anmeldetag: 03.07.2009
(51) Int. Cl.: H01L 25/07, H01L 23/48

(54) **Leistungshalbleitermodul**
High power semiconductor module
Module semi-conducteur de puissance

(30) Priorität: 22.07.2008 DE 102008034068
(43) Veröffentlichungstag der Anmeldung: 27.01.2010
(73) Patentinhaber: Semikron Elektronik GmbH & Co. KG Patentabteilung, 90431 Nürnberg (DE)
(72) Erfinder: Popp, Rainer, 91580 Petersaubach (DE); Gruber, Markus, 90518 Altdorf (DE)

(56) Entgegenhaltungen:
- EP-A- 1 450 404
- EP-A- 1 592 063
- WO-A-03/034467
- DE-C1- 10 231 219
- US-A- 5 296 739

## Beschreibung

Die Erfindung betrifft ein Leistungshalbleitermodul mit einem Substrat, einem Gehäuse und einem Brückenelement, wobei das Substrat an einer ersten Hauptfläche Leiterbahnen für Lastanschlusselemente und für Leistungshalbleiterbauelemente und auf der gegenüberliegenden zweiten Hauptfläche eine Metalllage aufweist, die zur Wärmeableitung an ein Kühlbauteil vorgesehen ist, wobei das Gehäuse am Kühlbauteil fixierbar ist, und wobei das Brückenelement im Gehäuse angeordnet und zur Positionierung von Kontaktabschnitten der Lastanschlusselemente in Bezug zu den Leiterbahnen des Substrates vorgesehen ist und mit Drückelementen gegen die erste Hauptfläche des Substrates drückt.

Bei dem Substrat handelt es sich beispielsweise um ein DCB-Substrat (Direct Copper Bonding). An derartige Leistungshalbleitermodule wird die Forderung gestellt, dass sie im Temperaturbereich von -30°C bis 150°C während einer langen Einsatzdauer zuverlässig funktionieren. Ein solcher großer Temperaturbereich resultiert in entsprechenden wärmeausdehnungsbedingten Dimensionsänderungen.

Ein Leistungshalbleitermodul der eingangs genannten Art ist beispielsweise in der DE 10 2006 006 424 A1 der Anmelderin offenbart. Bei diesem bekannten Leistungshalbleitermodul bilden das Kühlbauteil mit dem an diesem fixierten Gehäuse und dem im Gehäuse vorgesehenen Brückenelement eine erste Baueinheit und das Substrat mit den an ihm schaltungsgerecht angebrachten Leistungshalbleiterbauelementen und den Lastanschlusselementen eine zweite Baueinheit. Diese beiden bekannten Baueinheiten weisen zueinander keine mechanisch starre Verbindung zueinander auf, vielmehr kann sich die zweite Baueinheit in lateraler Richtung innerhalb der ersten Baueinheit bewegen, wie in Absatz [0030] dieses druckschriftlichen Standes der Technik beschrieben ist. Bei diesem bekannten Leistungshalbleitermodul kann sich also das Substrat in Bezug zum Gehäuse temperaturbedingt begrenzt bewegen. In dem umlaufenden Spalt zwischen dem Außenrand des Substrates und dem zugehörigen Befestigungsrand des Gehäuses befindet sich eine elektrisch isolierende Vergussmass, um die an der ersten Hauptfläche des Substrates vorgesehenen Leiterbahnen in Bezug zum Kühlbauteil elektrisch zu isolieren. Die ausgehärtete Vergussmasse besitzt eine hohe Dielektrizitätskonstante, um eine entsprechende Durchschlagfestigkeit zu gewährleisten. Infolge der temperaturbedingten begrenzten Beweglichkeit des Substrates in Bezug zu dem am Kühlbauteil fixierten Gehäuse ist bei diesem bekannten Leistungshalbleitermodul jedoch nicht zuverlässig auszuschließen, dass die ausgehärtete Vergussmasse aufbricht, so dass sich ein unerwünschter Luftspalt mit der entsprechenden Dielektrizitätskonstante ε₀ für Luft ergibt und die Durchschlagfestigkeit entsprechend der Reduktion der Dielektrizitätskonstante ε der ausgehärteten Vergussmasse zum Wert der Dielektrizitätskonstante ε₀ für Luft entsprechend reduziert. Das bedeutet, dass die Lebensdauer des Leistungshalbleitermoduls entsprechend reduziert sein kann.

Aus der WO 03/034467 A ist ein Leistungshalbleitermodul zur Montage an einem Kühlelement mit mindestens einem Substrat, auf dem sich ein oder mehrere Halbleiterbauelemente befinden, und einer auf das Substrat einwirkenden Anpressvorrichtung, um das Substrat im montierten Zustand an das Kühlelement anzupressen, wobei die Anpressvorrichtung von einem Modulgehäuse mit einem oder mehreren federelastischen Bereichen gebildet ist, bekannt.

Aus der DE 102 31 219 C1 ist ein Halbleiterrelais bestehend aus einem keramischen Substrat mit einer strukturierten metallkaschierten Oberfläche, darauf schaltungsgerecht angeordneten Halbleiterbauelementen, einem mehrteiligen Gehäuse mit Ausnehmungen zur Befestigung auf einem Grund- oder Kühlkörper, von Kontaktflächen des Substrats zu Kontaktelementen führenden Leistungsanschlusselementen, von weiteren Kontaktflächen des Substrats zu einer Steuereinrichtung führenden Hilfsanschlusselementen, bekannt, wobei diese Anschlusselemente in einem Teilabschnitt federnd ausgeführt sind, diese Anschlusselemente durch Durchführungen und/oder Ausnehmungen des ersten und/oder weiteren Teilkörpers des Gehäuses mit dem Substrat kontaktiert sind und diese Anschlusselemente sowie die Kontaktelemente durch ein erstes und ein weiteres mittels einer Schnappverbindung miteinander verbundenes Gehäuseteil in ihrer Lage fixiert sind.

In Kenntnis dieser Gegebenheiten liegt der Erfindung die Aufgabe zugrunde, ein Leistungshalbleitermodul der eingangs genannten Art zu schaffen, das bei einem einfachen Aufbau eine hohe Betriebszuverlässigkeit besitzt.

Diese Aufgabe wird erfindungsgemäß durch ein Leistungshalbleitermodul mit einem Substrat, einem Gehäuse und einem Brückenelement, wobei das Substrat an einer ersten Hauptfläche Leiterbahnen für Lastanschlusselemente und für Leistungshalbleiterbauelemente und auf der gegenüberliegenden zweiten Hauptfläche eine Metalllage aufweist, die zur Wärmeableitung an ein Kühlbauteil vorgesehen ist, das Gehäuse am Kühlbauteil fixierbar ist, und das Brückenelement im Gehäuse angeordnet und zur Positionierung von Kontaktabschnitten der Lastanschlusselemente in Bezug zu den Leiterbahnen des Substrates vorgesehen ist, wobei das Substrat mit dem Brückenelement eine Baueinheit bildet, die im Gehäuse in allen zur ersten und zweiten Hauptfläche des Substrates parallelen lateralen Richtungen begrenzt beweglich angeordnet ist, wobei das Brückenelement kappenartig mit einer umlaufenden Seitenwandung und mit Führungsschächten für die Kontaktabschnitte der Lastanschlusselemente ausgebildet ist, und dass das Gehäuse ein Rahmenelement und ein Deckelelement aufweist, wobei das Brückenelement mit Drückelementen gegen die erste Hauptfläche des Substrates drückt, wobei das Brückenelement mit den Drückelementen ausgebildet ist.

Bei dem aufgezeigten Leistungshalbleitermodul bildet also das Substrat nicht mit dem am Kühlbauteil fixierbaren Gehäuse sondern mit dem im Gehäuse begrenzt beweglich vorgesehenen Brückenelement eine Baueinheit. Entlang des umlaufenden Randes des Substrates und des zugehörigen Befestigungsrandes des Brückenelementes ist eine elektrisch isolierende Vergussmasse vorgesehen, wobei ein Aufbrechen der ausgehärteten Vergussmasse zuverlässig ausgeschlossen ist, weil zwischen dem Brückenelement und dem Substrat, die eine Baueinheit bilden, temperaturbedingte Relativbewegungen ausgeschlossen und somit eine die Durchschlagfestigkeit reduzierende Luftspaltbildung verhindert wird. Das erfindungsgemäße Leistungshalbleitermodul besitzt folglich bei einem einfachen Aufbau während einer langen Lebensdauer eine ausgezeichnete Betriebszuverlässigkeit.

Als zweckmäßig hat es sich bei dem aufgezeigten Leistungshalbleitermodul erwiesen, dass das Brückenelement kappenartig mit einer umlaufenden Seitenwandung, mit den Drückelementen und mit Führungsschächten für die Kontaktabschnitte der Lastanschlusselemente ausgebildet ist, und dass das Gehäuse ein Rahmenelement und ein Deckelelement aufweist. Die Seitenwandung des Brückenelementes ist dabei vom Rahmenelement des Gehäuses durch einen kleinen Spalt beabstandet, so dass wärmeausdehnungsbedingte Bewegungen der Baueinheit aus Substrat und Brückenelement in Bezug zu dem an einem Kühlbauteil zu fixierenden bzw. fixierten Gehäuse problemlos möglich sind, ohne die Durchschlagfestigkeit des Leistungshalbleitermoduls in Bezug zu dem Kühlbauteil zu beeinflussen.

Bei dem aufgezeigten Leistungshalbleitermodul ist es bevorzugt, wenn die umlaufende Seitenwandung des Brückenelementes mit einem für den umlaufenden Rand des Substrates vorgesehenen, umlaufenden Kragen ausgebildet ist, dessen lichte Innenabmessungen an den Außenrand des Substrates angepasst ist. Dabei ist der umlaufende Kragen der Seitenwandung des Brückenelementes derartig gestaltet, dass das Substrat mit der an seiner zweiten Hauptfläche vorgesehenen Metalllage geringfügig über den umlaufenden Kragen übersteht, so dass eine zuverlässige großflächige Anlage der Metalllage des Substrates an einem Kühlbauteil gewährleistet wird.

Um zwischen dem Brückenelement und dem Gehäuse die oben erwähnte definierte begrenzte Beweglichkeit zu gewährleisten, ist es bevorzugt, wenn die umlaufende Seitenwandung des Brückenelementes Außenabmessungen aufweist, die geringfügig kleiner sind als die lichten Innenabmessungen des Rahmenelementes des Gehäuses.

Als zweckmäßig hat es sich erwiesen, wenn das Rahmenelement an seiner dem Deckelelement zugewandten Fläche mit Aussparungen für Anschlussabschnitte der Lastanschlusselemente und wenn das Deckelement an seiner dem Rahmenelemente zugewandten Fläche mit Ausnehmungen für die besagten Anschlussabschnitte der Lastanschlusselemente ausgebildet ist. Durch eine derartige Ausbildung ergibt sich der Vorteil, dass die Lastanschlusselemente einfach und zeitsparend montierbar sind. Die Anschlussabschnitte der Lastanschlusselemente stehen mit Kontaktfahnen vorzugsweise über das Deckelelement des Gehäuses frei zugänglich über, so dass die Lastanschlusselemente des Leistungshalbleitermoduls problemlos extern verschaltbar sind.

Um das aufgezeigte Leistungshalbleitermodul einfach und zeitsparend an einem Kühlbauteil befestigen zu können, hat es sich als zweckmäßig erwiesen, wenn das Deckelelement und das Rahmenelement des Gehäuses mit axial fluchtenden Befestigungslöchern für Befestigungselemente ausgebildet sind, mittels welchen das Leistungshalbleitermodul an einem Kühlbauteil befestigbar ist. Bei den Befestigungselementen handelt es sich zum Beispiel um Schraubelemente, mittels welchen das Leistungshalbleitermodul an dem Kühlbauteil befestigt wird, wobei gleichzeitig der Anpressdruck des Brückenelementes gegen die Leiterbahnen an der ersten Hauptfläche des Substrates und der Kontaktdruck der Kontaktabschnitte der Lastanschlusselemente gegen die besagten Leiterbahnen bewirkt wird.

Weitere Einzelheiten, Merkmale und Vorteile ergeben sich aus der nachfolgenden Beschreibung eines in der Zeichnung dargestellten Ausführungsbeispieles des erfindungsgemäßen Leistungshalbleitermoduls.

Es zeigen:
- Figur 1: perspektivisch eine Ausbildung des Leistungshalbleitermoduls in einer Explosionsdarstellung,
- Figur 2: eine Seitenansicht des Leistungshalbleitermoduls gemäß Figur 1 in der Explosionsdarstellung,
- Figur 3: eine Schnittdarstellung des Leistungshalbleitermoduls gemäß Figur 2, und
- Figur 4: eine Schnittdarstellung des Leistungshalbleitermoduls im zusammengebauten Zustand sowie ein vergrößertes Detail desselben.

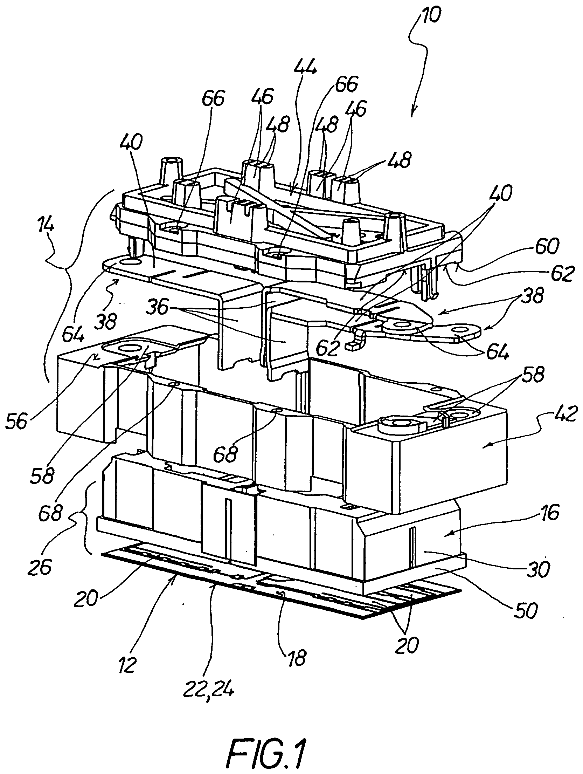

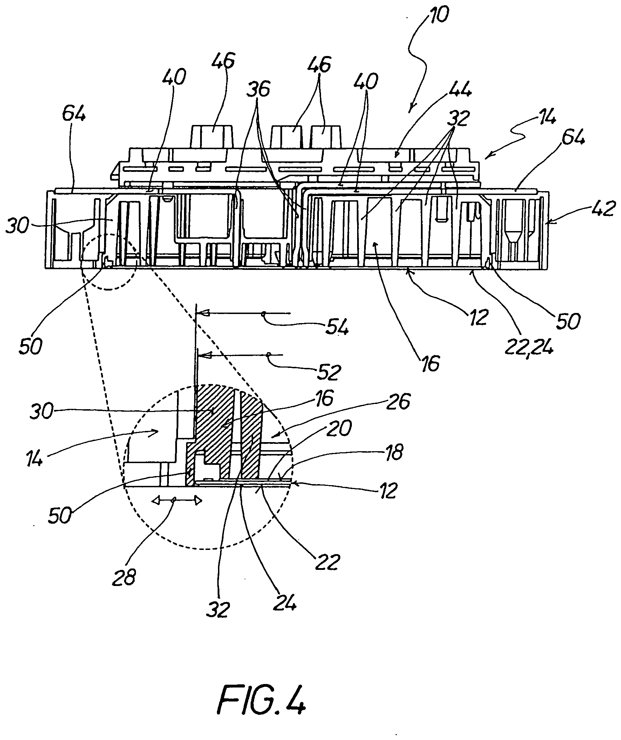

Figur 1 zeigt eine Ausbildung des Leistungshalbleitermoduls 10, das ein Substrat 12, ein Gehäuse 14 und ein Brückenelement 16 aufweist. Wie aus Figur 4 ersichtlich ist, weist das Substrat 12 an einer ersten Hauptfläche 18 Leiterbahnen 20 und (nicht dargestellte) Leistungshalbleiterbauelemente und auf der gegenüberliegenden zweiten Hauptfläche 22 eine Metalllage 24 auf. Die Metalllage 24 ist zur Wärmeableitung an ein nicht gezeichnetes Kühlbauteil vorgesehen.

Das Substrat 12 bildet mit dem Brückenelement 16 eine Baueinheit 26, die im Gehäuse 14 in allen zur ersten und zweiten Hauptfläche 18 und 22 parallelen lateralen Richtungen begrenzt beweglich ist. Diese begrenzte Beweglichkeit ist in Figur 4 durch den Doppelpfeil 28 angedeutet. Außerdem ist eine Bewegung in der zu den lateralen Richtungen senkrechten Richtung möglich.

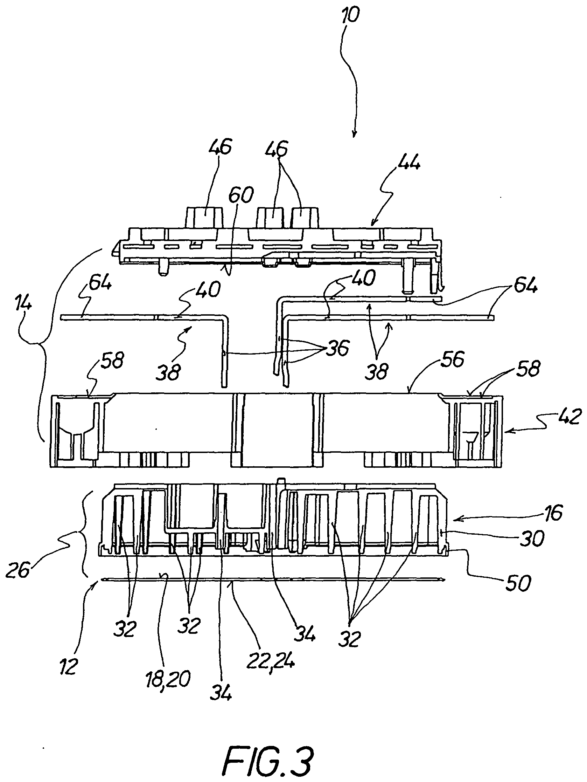

Wie aus Figur 3 ersichtlich ist, ist das Brückenelement 16 kappenartig mit einer umlaufenden Seitenwandung 30, mit fingerartigen Drückelementen 32 und mit Führungsschächten 34 ausgebildet. Die Führungsschächte 34 sind zur Positionierung von Kontaktabschnitten 36 vorgesehen, mit welchen Lastanschlusselementen 38 des Leistungshalbleitermoduls 10 ausgebildet sind. Von den Kontaktabschnitten 36 der Lastanschlusselemente 38 stehen Anschlussabschnitte 40 der Lastanschlusselemente 38 abgewinkelt weg.

Das Gehäuse 14 des Leistungshalbleitermoduls 10 weist ein Rahmenelement 42 und ein Deckelelement 44 auf. Vom Deckelelement 44 stehen Dome 46 weg, die für federnde Steuer- bzw. Hilfsanschlusselemente 48 vorgesehen sind, die im zusammengebauten Zustand des Leistungshalbleitermoduls 10 mit den am Substrat 12 vorgesehenen Leiterbahnen 20 passend kontaktiert sind.

Wie aus Figur 4 deutlich ersichtlich ist, ist die umlaufende Seitenwandung 30 des Brückenelementes 16 mit einem Kragen 50 ausgebildet, der zur Positionierung des Substrates 12 in lateraler Richtung vorgesehen ist. Zu diesem Zwecke sind die lichten Innenabmessungen des umlaufenden Kragens 50 an den Außenrand des Substrates 12 angepasst.

Damit zwischen der Baueinheit aus dem Brückenelement 16 und dem Substrat 12 und dem Gehäuse 14 bzw. dessen Rahmenelement 42 die weiter oben beschriebene und in Figur 4 durch den Doppelpfeil 28 verdeutlichte Beweglichkeit gewährleistet wird, weist die umlaufende Seitenwandung 30 des Brückenelementes 16 Außenabmessungen 52 auf, die geringfügig kleiner sind als die lichten Innenabmessungen 54 des Rahmenelementes 42 des Gehäuses 14 (siehe Figur 4).

Wie beispielsweise aus Figur 1 ersichtlich ist, ist das Rahmenelement 42 des Deckelelementes 44 an seiner dem Deckelelement 44 zugewandten Fläche 56 mit Aussparungen 58 für die Anschlussabschnitte 40 der Lastanschlusselemente 38 ausgebildet. Desgleichen ist das Deckelelement 44 an seiner dem Rahmenelement 42 des Gehäuses 14 zugewandten Innenfläche 60 mit Ausnehmungen 62 für die Anschlussabschnitte 40 der Lastanschlusselemente 38 ausgebildet. Die Anschlussabschnitte 40 der Lastanschlusselemente 38 stehen mit Kontaktfahnen 64 über den Außenrand des Deckelelementes 44 des Gehäuses 14 frei zugänglich über.

Das Deckelelement 44 und das Rahmenelement 42 des Gehäuses 14 sind mit axial fluchtenden Befestigungslöchern 66 und 68 ausgebildet. Im zusammengebauten Zustand des Leistungshalbleitermoduls 10 dienen die Befestigungslöcher 66 oder 68 zur Aufnahme von nicht gezeichneten Befestigungselementen, mittels welchen das Leistungshalbleitermodul 10 an einem Kühlbauteil befestigbar ist.

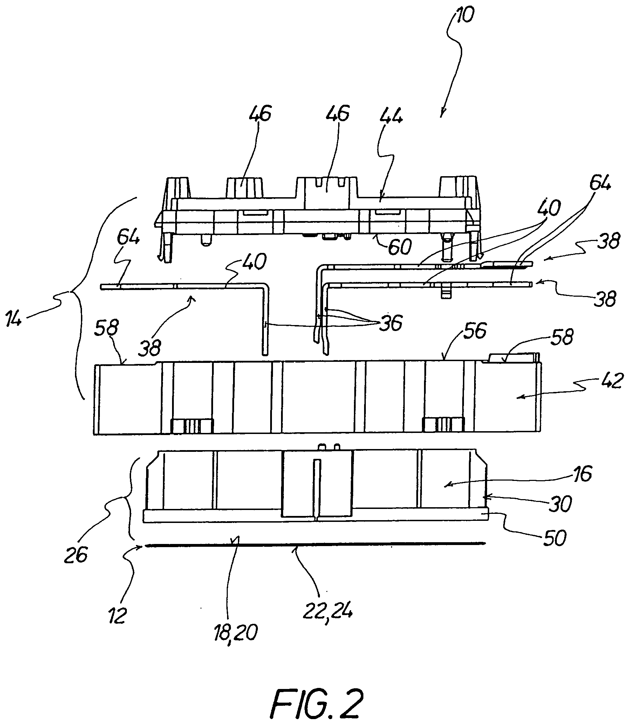

Gleiche Einzelheiten sind in den Figuren 1 bis 4 jeweils mit denselben Bezugsziffern bezeichnet, so dass es sich erübrigt, in Verbindung mit allen Figuren alle Einzelheiten jeweils detailliert zu beschreiben.

### Bezugsziffernliste:

- 10: Leistungshalbleitermodul
- 12: Substrat (von 10)
- 14: Gehäuse (von 10)
- 16: Brückenelement (von 10)
- 18: erste Hauptfläche (von 12)
- 20: Leiterbahnen (an 18)
- 22: zweite Hauptfläche (von 12)
- 24: Metalllage (an 22)
- 26: Baueinheit (von 12 mit 16)
- 28: Doppelpfeil / Beweglichkeit (zwischen 26 und 14)
- 30: umlaufende Seitenwandung (von 16)
- 32: Drückelemente (von 16 für 12)
- 34: Führungsschächte (in 16 für 36)
- 36: Kontaktabschnitte (von 38)
- 38: Lastanschlusselemente (von 10)
- 40: Anschlussabschnitte (von 38)
- 42: Rahmenelement (von 14)
- 44: Deckelelement (von 14)
- 46: Dome (an 44 für 48)
- 48: Steuer- bzw. Hilfsanschlusselemente (von 10)
- 50: umlaufender Kragen (von 30 für 12)
- 52: Außenabmessungen (von 30)
- 54: lichte Innenabmessungen (von 42)
- 56: Fläche (von 42)
- 58: Aussparungen (in 56)
- 60: Innenfläche (von 44)
- 62: Ausnehmungen (in 60)
- 64: Kontaktfahnen (von 40)
- 66: Befestigungslöcher (in 44)
- 68: Befestigungslöcher (in 42)

## Patentansprüche

1. Leistungshalbleitermodul mit einem Substrat (12), einem Gehäuse (14) und einem Brückenelement (16),
wobei das Substrat (12) an einer ersten Hauptfläche (18) Leiterbahnen (20) für Lastanschlusselemente (38) und für Leistungshalbleiterbauelemente und auf der gegenüberliegenden zweiten Hauptfläche (22) eine Metalllage (24) aufweist, die zur Wärmeableitung an ein Kühlbauteil vorgesehen ist,
das Gehäuse (14) am Kühlbauteil fixierbar ist, und
das Brückenelement (16) im Gehäuse (14) angeordnet und zur Positionierung von Kontaktabschnitten (36) der Lastanschlusselemente (38) in Bezug zu den Leiterbahnen (20) des Substrates (12) vorgesehen ist, wobei das Substrat (12) mit dem Brückenelement (16) eine Baueinheit (26) bildet, die im Gehäuse (14) in allen zur ersten und zweiten Hauptfläche (18 und 22) des Substrates (12) parallelen lateralen Richtungen begrenzt beweglich angeordnet ist, wobei das Brückenelement (16) kappenartig mit einer umlaufenden Seitenwandung (30), und mit Führungsschächten (34) für die Kontaktabschnitte (36) der Lastanschlusselemente (38) ausgebildet ist, und dass das Gehäuse (14) ein Rahmenelement (42) und ein Deckelelement (44) aufweist, wobei das Brückenelement (16) mit Drückelementen (32) gegen die erste Hauptfläche (18) des Substrates (12) drückt, **dadurch gekennzeichnet, dass** das Brückenelement (16) mit den Drückelementen (32) ausgebildet ist.

2. Leistungshalbleitermodul nach Anspruch 1, wobei die Baueinheit (26) aus dem Substrat (12) und dem Brückenelement (16) in der zu den lateralen Richtungen senkrechten Richtung begrenzt beweglich ist.

3. Leistungshalbleitermodul nach Anspruch 1 oder 2, wobei die umlaufende Seitenwandung (30) des Brückenelementes (16) mit einem für das Substrat (12) vorgesehenen umlaufenden Kragen (50) ausgebildet ist, dessen lichte Innenabmessungen an den Außenrand des Substrates (12) angepasst ist.

4. Leistungshalbleitermodul nach Anspruch 1 oder 2, wobei die umlaufende Seitenwandung (30) des Brückenelementes (16) Außenabmessungen (52) aufweist, die geringfügig kleiner sind als die lichten Innenabmessungen (54) des Rahmenelementes (42) des Gehäuses (14).

5. Leistungshalbleitermodul nach Anspruch 1 oder 2, wobei das Rahmenelement (42) des Gehäuses (14) an seiner dem Deckelelement (44) zugewandten Fläche (56) mit Aussparungen (58) für Anschlussabschnitte (40) der Lastanschlusselemente (38) und das Deckelelement (44) des Gehäuses (14) an seiner dem Rahmenelement (42) zugewandten Fläche (60) mit Ausnehmungen (62) für die Anschlussabschnitte (40) der Lastanschlusselemente (38) ausgebildet ist.

6. Leistungshalbleitermodul nach Anspruch 5, wobei die Anschlussabschnitte (40) der Lastanschlusselemente (38) mit Kontaktfahnen (64) über das Deckelelement (44) des Gehäuses (14) frei zugänglich überstehen.

7. Leistungshalbleitermodul nach Anspruch 1 oder 2, wobei das Deckelelement (44) und das Rahmenelement (42) des Gehäuses (14) mit axial fluchtenden Befestigungslöchern (66, 68) für Befestigungselemente ausgebildet sind, mittels welchen das Leistungshalbleitermodul (10) an einem Kühlbauteil befestigbar ist.

## Claims

1. Power semiconductor module having a substrate (12), a package (14) and a bridge element (16), wherein the substrate (12) has, on a first main face (18), interconnects (20) for load connection elements (38) and for power semiconductor components and, on the opposite second main face (22), a metal layer (24) which is provided for heat dissipation to a cooling component,
the package (14) can be fixed on the cooling component, and
the bridge element (16) is arranged in the package (14) and is provided for the purpose of positioning contact sections (36) of the load connection elements (38) relative to the interconnects (20) on the substrate (12), wherein the substrate (12) and the bridge element (16) form a unit (26) which is arranged in the package (14) with limited movement in all lateral directions parallel to the first and second main faces (18 and 22) of the substrate (12), wherein the bridge element (16) is in cap-like form with a circumferential side wall (30), and with guide shafts (34) for the contact sections (36) of the load connection elements (38), and wherein the package (14) has a frame element (42) and a cover element (44), wherein the bridge element (16) presses with pushing elements (32) against the first main face (18) of the substrate (12), **characterized in that**
the bridge element (16) is produced with the pushing elements (32).

2. Power semiconductor module according to Claim 1, wherein the unit (26) comprising the substrate (12) and the bridge element (16) has limited movement in the direction perpendicular to the lateral directions.

3. Power semiconductor module according to Claim 1 or 2, wherein the circumferential side wall (30) of the bridge element (16) is produced with a circumferential collar (50) which is provided for the substrate (12) and whose clear internal dimensions match the outer edge of the substrate (12).

4. Power semiconductor module according to Claim 1 or 2, wherein the circumferential side wall (30) of the bridge element (16) has external dimensions (52) which are slightly smaller than the clear internal dimensions (54) of the frame element (42) of the package (14).

5. Power semiconductor module according to Claim 1 or 2, wherein the frame element (42) of the package (14) is produced with cut-outs (58) for connection sections (40) of the load connection elements (38) on its face (56) which faces the cover element (44), and the cover element (44) of the package (14) is produced with cut-outs (62) for the connection sections (40) of the load connection elements (38) on its face (60) which faces the frame element (42).

6. Power semiconductor module according to Claim 5, wherein the connection sections (40) of the load connection elements (38) have contact lugs (64) protruding above the cover element (44) of the package (14) in freely accessible form.

7. Power semiconductor module according to Claim 1 or 2, wherein the cover element (44) and the frame element (42) of the package (14) are produced with axially flush mounting holes (66, 68) for mounting elements which can be used to mount the power semiconductor module (10) on a cooling component.

## Revendications

1. Module semi-conducteur de puissance avec un substrat (12), un boîtier (14) et un élément en pont (16),
le substrat (12) présentant sur une première surface principale (18) des pistes conductrices (20) pour les éléments de bornes de charge (38) et pour des éléments semi-conducteurs de puissance et, sur la deuxième surface principale (22) opposée, une couche métallique (24) qui est prévue pour l'évacuation de chaleur sur un composant de refroidissement,
le boîtier (14) pouvant être fixé sur le composant de refroidissement, et
l'élément en pont (16) étant disposé dans le boîtier (14) et étant prévu pour le positionnement de tronçons de contact (36) des éléments de bornes de charge (38) par rapport aux pistes conductrices (20) du substrat (12), le substrat (12) formant avec l'élément en pont (16) une unité de montage (26) qui est disposée de façon mobile dans le boîtier (14) en étant limitée dans toutes les directions latérales parallèles à la première et à la deuxième surface principale (18 et 22) du substrat (12), l'élément en pont (16) étant constitué en forme de capuchon avec une paroi latérale (30) périphérique, et avec des puits de guidage (34) pour les tronçons de contact (36) des éléments de bornes de charge (38), et en ce que le boîtier (14) présente un élément de cadre (42) et un élément de couvercle (44), l'élément en pont (16) pressant avec des éléments de pression (32) contre la première surface principale (18) du substrat (12), **caractérisé en ce que** l'élément en pont (16) est constitué avec les éléments de pression (32).

2. Module semi-conducteur de puissance selon la revendication 1, l'unité de montage (26) étant mobile à partir du substrat (12) et de l'élément en pont (16) en étant limitée dans la direction perpendiculaire aux directions latérales.

3. Module semi-conducteur de puissance selon la revendication 1 ou 2, la paroi latérale (30) périphérique de l'élément en pont (16) étant constituée avec une collerette (50) périphérique, prévue pour le substrat (12), dont les dimensions intérieures de passage sont adaptées au bord extérieur du substrat (12).

4. Module semi-conducteur de puissance selon la revendication 1 ou 2, la paroi latérale (30) périphérique de l'élément en pont (16) présentant des dimensions extérieures (52) qui sont légèrement inférieures aux dimensions intérieures de passage (54) de l'élément de cadre (42) du boîtier (14).

5. Module semi-conducteur de puissance selon la revendication 1 ou 2, l'élément de cadre (42) du boîtier (14) étant, sur sa surface (56) tournée vers l'élément de couvercle (44), constitué avec des évidements (58) pour des tronçons de bornes (40) des éléments de bornes de charge (38), et l'élément de couvercle (44) du boîtier (14) étant, sur sa surface (60) tournée vers l'élément de cadre (42), constitué avec des évidements (62) pour les tronçons de bornes (40) des éléments de bornes de charge (38).

6. Module semi-conducteur de puissance selon la revendication 5, les tronçons de bornes (40) des éléments de bornes de charge (38) dépassant de façon librement accessible, par des talons de contact (64), de l'élément de couvercle (44) du boîtier (14).

7. Module semi-conducteur de puissance selon la revendication 1 ou 2, l'élément de couvercle (44) et l'élément de cadre (42) du boîtier (14) étant constitués avec des trous de fixation (66, 68), en affleurement axialement, pour des éléments de fixation au moyen desquels le module semi-conducteur de puissance (10) peut être fixé sur un composant de refroidissement.
